(19) **Europäisches Patentamt / European Patent Office / Office européen des brevets**

(11) **EP 1 791 100 B1**

(12) **EUROPÄISCHE PATENTSCHRIFT**

(45) Veröffentlichungstag und Bekanntmachung des Hinweises auf die Patenterteilung:
**10.09.2008   Patentblatt 2008/37**

(51) Int Cl.:
*G08C 15/06* (2006.01)     *G08C 17/02* (2006.01)
*H03H 9/02* (2006.01)

(21) Anmeldenummer: **06021420.2**

(22) Anmeldetag: **12.10.2006**

(54) **Funkübertragungssystem mit kompensierter Senderfrequenzstabilität und entsprechendem Funkempfangsfrequenz-Suchlauf**

Radio transmission system with compensated stability of the transmitting frequency and corresponding search of receiving frequency

Système de transmission sans fil avec stabilité de fréquence de diffusion compensé et recherche de fréquence de réception correspondante

(84) Benannte Vertragsstaaten:
**AT CH DE FR LI**

(30) Priorität: **29.11.2005   DE 102005056932**

(43) Veröffentlichungstag der Anmeldung:
**30.05.2007   Patentblatt 2007/22**

(73) Patentinhaber: **Prof. Dr. Horst Ziegler und Partner GbR**
**33100 Paderborn (DE)**

(72) Erfinder: **Ziegler, Horst, Prof. Dr.**
**33100 Paderborn (DE)**

(74) Vertreter: **Tiesmeyer, Johannes et al**
**Weickmann & Weickmann**
**Patentanwälte**
**Postfach 86 08 20**
**81635 München (DE)**

(56) Entgegenhaltungen:
**EP-A- 1 028 403         EP-A- 1 223 673**
**EP-A1- 1 077 438        EP-A1- 1 605 582**
**DE-A1- 4 225 042**

**Beschreibung**

Die Erfindung betrifft ein Funkübertragungssystem mit wenigstens einem Funksender, der eine Sendesteuerschaltung aufweist und dazu eingerichtet ist, nach einem bestimmten Sendezeitschema Funktelegramme in Zeitintervallen mit dazwischen liegenden Pausen zu senden, und mit wenigstens einem Funkempfänger, der eine Empfangssteuerschaltung umfasst, die dazu eingerichtet ist, den Funkempfänger nach Maßgabe des Sendezeitschemas für die Dauer jeweiliger Empfangsbereitschaftszeitintervalle empfangsbereit zu schalten, um Funktelegramme von dem Funksender zu empfangen, wobei der Funksender einen Zeitgeber mit Zeitmessmitteln zur Bestimmung der Sendezeitpunkte und einen Trägerfrequenzgeber zur Bereitstellung der Funksendefrequenz umfasst.

Funkübertragungssysteme der hier betrachteten Art kommen z.B. im Gebäudeverwaltungsbereich zum Einsatz, etwa bei der Verbrauchsdatenerfassung betreffend den Heizmittelverbrauch, Wasserverbrauch, Gasverbrauch oder Stromverbrauch in einer Wohnung oder sonstigen Gebäudenutzungseinheit. Derartige Funkübertragungssysteme und damit ausgestattete Verbrauchsdaten-Erfassungssysteme sind z.B. aus der EP 1 028 403 A2, der EP 1 037 185 A2 oder der EP 1 392 078 A2 bekannt. Bei solchen Verbrauchsdaten-Erfassungssystemen sind in den betreffenden Nutzungseinheiten eines Gebäudes vorgesehene Verbrauchszähler mit Funksendern ausgestattet, die Zählerstandsdaten und Kennungsinformationen zur Verbrauchszähleridentifizierung zu bestimmten bzw. pseudostochastisch eingerichteten Sendezeitintervallen senden. Diesen Funksenderendgeräten sind Funkempfänger zugeordnet, welche die Funktelegramme empfangen und daraus abgeleitete Daten ggf. über weitere Stationen an eine Abrechnungszentrale senden. Bei den Funksenderendgeräten handelt es sich häufig um batteriebetriebene Geräte mit unidirektionalem Funkbetrieb und somit ohne Funkempfangsfunktion. Der Stromverbrauch der Verbrauchsmessgeräte und ihrer Funksender sollte möglichst gering sein, damit Langzeitbatterien als elektrische Energiequellen verwendet werden können und somit nur seltener Batterieaustauschbedarf bei den Geräten vorliegt.

Die Funksender der hier betrachteten Art sind vorzugsweise für einen entsprechenden Energie sparenden Betrieb ausgelegt, was sich darin äußert, dass sie nicht im Dauerbetrieb senden, sondern Funktelegramme nach einem Sendezeitschema in Zeitintervallen mit dazwischen liegenden Pausen senden. Im Falle eines Verbrauchsmessgerätes kann es ausreichen, wenn der Funksender die Funktelegramme mit den Verbrauchsmessdaten und Kennungsinformationen nur gelegentlich in kleinen Sendezeitfenstern überträgt, so dass sich die Phasen erhöhten Strombedarfs des Verbrauchsmessgerätes auf diese Sendezeitfenster im Wesentlichen beschränken.

In diesem Zusammenhang kann zum Stand der Technik auf die EP 1 028 403 A2 verwiesen werden, aus der ein Funkübertragungssystem der hier betrachteten Art als Bestandteil eines Verbrauchsdaten-Erfassungssystems bekannt ist. Bei dem Datenübertragungssystem nach der EP 1 028 403 A2 wird bei gegebener Zuordnung zwischen einem jeweiligen Funksender eines Endgerätes (z.B. Wärmemengenzählers) und einem Funkempfänger von der Möglichkeit der präzisen Abschätzung des Zeitpunktes der nächsten Datensendung vom Sender zum Empfänger Gebrauch gemacht. Dabei wird folgendem Umstand Rechnung getragen. Jeder der Sender und auch der Empfänger haben jeweils einen eigenen Zeitgeber mit einer eigenen Zeitbasis, die üblicherweise von einem Oszillator mit einem Uhren-Schwingquarz als Taktgeber gebildet wird. Aus Kostengründen kann man bei den üblicherweise in großer Anzahl erforderlichen Funksendern eines Verbrauchsdaten-Erfassungssystems nur Schwingquarze mit mäßiger Frequenzgenauigkeit bzw. Frequenzstabilität einsetzen. Aufgrund von Fertigungstoleranzen der eingesetzten Schwingquarze und vor allem aufgrund der starken Temperaturabhängigkeit der Frequenz der Schwingquarze kann es dazu kommen, dass der Zeitgeber eines Funksenders und der Zeitgeber des ihm zugeordneten Funkempfängers unterschiedlichen Gang aufweisen. Der Temperatureffekt auf die Zeitgeberfrequenz kann insbesondere bei den Funksendern elektronischer Heizkostenverteiler, Warmwasserzähler und Wärmemengenzähler, die Umgebungstemperaturen von bis zu 80° und entsprechenden Temperaturänderungen ausgesetzt sein können, Probleme bereiten, da die instantane Zeitgeberfrequenz und erst recht die daraus akkumulierte Zeit nach Maßgabe der Temperaturschwankungen variieren kann. In einem realistischen Beispiel kann eine Zeitunsicherheit von ca. +/- 3 Sekunden bei einem mittleren Sendeabstand von z.B. ca. 5 Stunden aus der Frequenzunsicherheit resultieren. Um ein zu einem bestimmten Zeitpunkt erwartetes Datenpaket von einem Sender mit großer Wahrscheinlichkeit empfangen zu können, ist es daher erforderlich, den Empfänger während eines Toleranzzeitintervalls (Empfangsbereitschafts-Zeitintervall) um den vermuteten Zeitpunkt herum empfangsbereit zu halten. Trifft das Funktelegramm in diesem Empfangsbereitschafts-Zeitintervall ein, so kann die Zeitzählung empfängerseitig auf den Eintreffzeitpunkt des Datenpakets neu bezogen werden und somit relativ zum Sender resynchronisiert werden. Auf diese Weise kann eine durchlaufende Akkumulation des Zeitfehlers verhindert werden.

Bei dem Datenübertragungssystem nach der EP 1 028 403 A2 weist der jeweilige Funkempfänger eine Empfangssteuerschaltung zur zeitlichen Steuerung seines Empfangsbetriebs auf, die auf der Basis von Sollwerten für die Zeitabstände aufeinander folgender Funktelegrammsendungen des betreffenden Senders den jeweiligen Zeitpunkt der erwarteten nächsten Datensendung abschätzt, d.h. kalkuliert, und den Empfänger zeitweilig jeweils in einem Empfangsbereitschafts-Zeitintervall, das den geschätzten Zeitpunkt enthält, empfangsbereit schaltet. Diese Empfangsbereitschafts-Zeitintervalle des Funkempfängers sollten möglichst kurz sein, um den Funkkanal möglichst selten zu besetzen und ferner den elektrischen Energiebedarf des Funkempfängers niedrig zu halten. Auch der Funkempfänger kann ein batteriebetriebenes Gerät sein.

Das Sendezeitschema kann beinhalten, dass die Funksender zu ihnen zugeordneten festen Zeiten, z.B. periodisch ihre Funktelegramme senden, wobei die Sendezeiten dem betreffenden Funkempfänger bekannt sind. Die Sendezeiten können in einem elektronischen Speicher des Funkempfängers abgelegt sein oder ggf. nach einem bestimmten Algorithmus jeweils berechnet werden. Das Sendezeitschema kann auch beinhalten, dass die Sendezeiten pseudostochastisch nach einem für den betreffenden Funksender und den Funkempfänger verbindlichen Algorithmus jeweils bestimmt werden. Derartige Sendezeitschemen sind dem Fachmann bekannt, so dass sich detailliertere Erläuterungen hierzu erübrigen.

Insbesondere für stationäre Funkübertragungssysteme ist die Reichweite der Funkverbindung zwischen Funksendern und einem den Sendern zugeordneten Funkempfänger insbesondere auch von großer wirtschaftlicher Bedeutung. Die Anzahl an Funksendern, von denen ein Funkempfänger Funktelegrammsendungen sicher empfangen kann (Ausstattungsfaktor), hängt nämlich wesentlich von der Reichweite ab. Im Falle eines Verbrauchsdaten-Erfassungssystems wird bei hoher Funkreichweite des darin einbezogenen Funkübertragungssystems in vielen Fällen ein Funkempfänger je Liegenschaft oder je Treppenhaus genügen, wohingegen bei geringer Funkreichweite meist in jedem Stockwerk ein solcher Treppenhaus-Funkempfänger vorhanden sein muss, um die Funktelegrammsendungen aller mit Funksendern ausgestatteten Verbrauchsmessgeräte in dem betreffenden Gebäude erfassen zu können. Da ein solcher Primär-Funkempfänger erheblich teurer ist als ein mit Funksender ausgestattetes Endgerät, spielen seine auch auf die ihm zugeordneten Endgeräte umgelegten Kosten für Fertigung, Montage und Inbetriebnahme eine wesentliche Rolle bei der Beurteilung der Wirtschaftlichkeit eines Verbrauchsdaten-Erfassungssystems mit Funkfernablesung. Eine Steigerung der Sendeleistung der Funksender wäre eine Möglichkeit der Reichweitenvergrößerung. Diese Möglichkeit ist jedoch bei den Endgeräten durch die Zulassungsgrenzen des Frequenzbandes, durch die Kosten für die aufwendigeren Sendekomponenten und auch durch die Leistungsfähigkeit und Größe der Batterie bzw. des Pufferkondensators begrenzt. Eine weitere Einflusskomponente für die Funkreichweite ist die Empfindlichkeit des Funkempfängers, die hauptsächlich durch die nutzbare Empfängerbandbreite bestimmt wird. Die Empfängerbandbreite kann bei heutigen Empfängerbausteinen in weiten Bereichen entweder durch Wahl eines geeigneten ZF-Filters oder bei digitalen ZF-Filtern sogar dynamisch frei gewählt werden. Die für eine hohe Empfangsempfindlichkeit und damit für eine funktechnisch hohe Reichweite erforderliche minimale Empfangsbandbreite erfordert üblicherweise eine langsame Modulation zur Erzielung einer kleinen Senderbandbreite. Langsame Modulation bedeutet aber, dass auch die Funktelegramme länger dauern, was wiederum unerwünscht ist, da dies einen zeitlich verlängerten Sende- und Empfangsbetrieb für die Datenübermittlung zwischen einem Sender und einem Empfänger bedeutet und somit eine größere Belastung der Stromversorgungsbatterien mit sich bringt. Bei den üblicherweise verwendeten hohen Funkfrequenzen (meist 868 MHz - 870 MHz) spielen die Frequenztoleranzen der Taktgeberquarze der Sender und Empfänger die dominante Rolle bei der Wahl der nutzbaren Empfängerbandbreite und somit bei der erreichbaren Empfangsempfindlichkeit und der Funkreichweite der betreffenden Funkverbindungen.

Aus Kostengründen werden in den Endgeräten mit Funksendern als Taktgeber für die Trägerfrequenz nur Quarze mit relativ großer Fertigungstoleranz und vergleichsweise starker Temperaturabhängigkeit der Schwingungsfrequenz eingesetzt. Bei den in geringerer Stückzahl erforderlichen Funkempfängern werden üblicherweise hochwertigere Schwingquarze als Taktgeber verwertet, deren Fertigungstoleranz und deren Abhängigkeit der Frequenz von der Temperatur relativ gering sind. Die für eine Funkverbindung zwischen Sender und Empfänger erforderliche effektive Empfängerbandbreite hängt somit dominant von der Frequenzgenauigkeit, also von Fertigungstoleranzen, Alterung und Temperatureinfluss des Senderquarzes ab. Zu gro-ße Abweichungen der vom Senderquarz bestimmten Sendefrequenz von einer am Empfänger eingestellten Soll-Empfangsfrequenz kann dazu führen, dass die Sendefrequenz außerhalb der Empfangsbandbreite des Empfängers liegt, so dass Funktelegrammsendungen des Senders von dem Empfänger nicht empfangen werden.

Bei Verbrauchsmessgeräten, die hohen Temperaturen ausgesetzt sind, etwa Heizkostenverteilern, Wärmemengenzählern o.dgl., kommt erschwerend hinzu, dass der die Sendefrequenz bestimmende Senderquarz stark schwankenden und teilweise hohen Temperaturen ausgesetzt ist, so dass seine Temperaturabhängigkeit der Frequenz eine viel größere Rolle spielt als die Temperaturabhängigkeit der Frequenz bei dem normalerweise nur den Raumtemperaturschwankungen ausgesetzten Quarzen des Empfängers. Bisher wurde die Empfängerbandbreite aus der Summe der Toleranzen der Frequenzen des Senderquarzes und des Empfängerquarzes zuzüglich der erforlichen Signalbandbreite bestimmt. Auf diese Weise ergibt sich eine relativ große Empfängerbandbreite und eine vergleichsweise geringe Empfangsempfindlichkeit mit der Folge, dass auch die Funkreichweite nicht sehr groß ist.

Etwas kleinere effektive Empfängerbandbreiten ließen sich realisieren, wenn ein Fertigungsabgleich der Senderquarze und Empfängerquarze vorgenommen würde. Ein solcher Fertigungsabgleich ist aber aufwendig und teuer und berücksichtigt nicht zeitliche Änderungen der Quarzfrequenz durch Alterung und Temperatureinflüsse. Klassische AFC-Frequenzregelungen wie beim Rundfunkempfang scheiden bei Funkübertragungssystemen der hier betrachteten Art aus, da die Funksender hier nur sehr kurze Funktelegramme in relativ großen Zeitabständen senden. Es wäre wünschenswert, auch bei solchen Sendestrukturen trotz der großen Frequenztoleranzen der in den Sendern verwendeten preiswerten Quarze mit einer möglichst kleinen und im Idealfall mit einer im Wesentlichen durch die Sendebandbreite des Nutzsignals bestimmten Empfängerbandbreite auszukommen.

Der Erfindung liegt die Aufgabe zugrunde, ein Funkübertragungssystem der eingangs genannten Art bereitzustellen, welches trotz vergleichsweise geringer Frequenzstabilität des Funksenders mit einer vergleichsweise kleinen Empfängerbandbreite betrieben werden kann und somit eine größere Funkreichweite erlaubt.

Zur Lösung dieser Aufgabe wird bei einem Funkübertragungssystem der eingangs genannten Art vorgeschlagen, dass die vom Zeitgeber des Funksenders gegebene Zeit von der Frequenz des Trägerfrequenzgebers als Referenztaktmaß abhängig ist und dass der Funkempfänger dazu eingerichtet ist, in einer Suchlauf-Betriebsart einen automatischen Funkempfangsfrequenz-Suchlauf mit abnehmender Funkempfangssuchfrequenz in den Empfangsbereitschafts-Zeitintervallen durchzuführen, um die Funkempfangsfrequenz des Funkempfängers auf die Funksendefrequenz des Funksenders abzustimmen.

Durch die erfindungsgemäße Verknüpfung des Zeitgebers mit dem Trägerfrequenzgeber des Funksenders kann erreicht werden, dass sich die Einflüsse des Zeitfehlers und des Trägerfrequenzfehlers des Funksenders zumindest teilweise kompensieren und so eine geringere Empfängerbandbreite ermöglichen.

Gemäß einer Variante des Funkübertragungssystems nach der Erfindung erfolgt die Verknüpfung zwischen Trägerfrequenzerzeugung und Zeiterfassung bei dem Funksender in einfacher Weise dadurch, dass der Zeitgeber des Funksenders seinen Zeittakt stets von dem Trägerfrequenzgeber erhält. Der die Sendefrequenz bestimmende HF-Quarz wird somit auch als Zeittaktquarz für das Zeitmanagement des Funksenders verwendet. Auf diese Weise sind dann der (akkumulierte) Uhrzeitfehler und der momentane Frequenzfehler des HF-Funksenders miteinander verknüpft. Ist die Frequenz des HF-Quarzes z.B. zu hoch, so läuft die Zeitgeberuhr etwas zu schnell. Für den Sendebetrieb bedeutet dies, dass die Sendung des nächsten Funktelegramms stets etwas früher als erwartet und mit der höheren Sendefrequenz erfolgt. Ist die HF-Quarzfrequenz dagegen im Vergleich mit dem Erwartungswert etwas zu niedrig, so erfolgt die Funktelegrammsendung stets etwas zu spät mit zu niedriger Funkfrequenz. Der Funkempfänger mit einer nur kleinen Empfangsbandbreite und damit hoher Empfindlichkeit (aber auch mit geringer Eigen-Frequenzfehlertoleranz) kann daher innerhalb seines durch die maximale Zeitfehlertoleranz vorgegebenen Zeitfensters zunächst seine Empfangsfrequenz höher einstellen und sie dann innerhalb des Zeitfensters (Empfangsbereitschaftszeitintervalls) entsprechend dem Zusammenhang zwischen Zeit- und Frequenzfehler kontinuierlich erniedrigen, bis er den Beginn des erwarteten Funktelegramms entdeckt. Daraufhin beendet der Funkempfänger den Funkempfangsfrequenz-Suchlauf, um das Funktelegramm mit der aufgefundenen Funkempfangsfrequenz zu empfangen.

Die jeweilige Suchlaufstartfrequenz und vorzugsweise auch die zeitliche Abnahmerate der Empfangsfrequenz beim Suchlauf hängt gemäß einer bevorzugten Weiterbildung der Erfindung von der Zeit seit dem letzten auswertbaren Empfang eines Funktelegramms von dem betreffenden Funksender ab, wobei dieses letzte auswertbare Empfangsereignis vorzugsweise zur Rekalibrierung sowohl der Zeitmessung als auch der HF-Frequenzeinstellung empfängerseitig verwendet wird. Ist seit dem letzten Empfangsereignis schon eine relativ lange Zeit vergangen, so wird die Empfangsfrequenz pro Zeiteinheit nur langsam herabgesetzt werden, denn auch ein kleiner Frequenzfehler wird sich über den relativ langen Zeitabstand in einen vergleichsweise großen Zeitfehler übersetzen. Dementsprechend wird der Funkempfänger auch das Empfangsbereitschafts-Zeitintervall vergrößern. Ist dagegen das letzte Funkempfangsereignis dem aktuellen Funksendeereignis erst kurzzeitig vorausgegangen, so wird der Funkempfänger seine Empfangsfrequenz bei dem Funkempfangsfrequenz-Suchlauf innerhalb des dann entsprechend kleineren Empfangsbereitschafts-Zeitintervalls rascher ändern. Insgesamt durchläuft die Funkempfangsfrequenz innerhalb des für die Berücksichtigung der Toleranz der HF-Quarzfrequenz des Funksenders erforderlichen Empfangsbereitschafts-Zeitintervalls vorzugsweise stets den gesamten Frequenztoleranzbereich, der der Zeitfensterbreite, d.h. der Dauer des Empfangsbereitschafts-Zeitintervalls entspricht. Es wird somit durch die Kopplung von Sendefrequenzerzeugung und Zeiterfassung bei dem Funksender erreicht, dass trotz der unvermeidlichen Zeitfehler die Empfängerbandbreite keinen großen Sendefrequenztoleranzzuschlag braucht. Der Funkempfangsfrequenz-Suchlauf und der Funkempfang können somit mit einer relativ kleinen Empfängerbandbreite erfolgen, die kaum größer als die zu reservierende Signalbandbreite sein muss.

Der Suchlauf könnte in einer Ausführungsform der Erfindung frequenzstufenweise erfolgen. Vorzugsweise ist der Funkempfänger jedoch dazu eingerichtet, den Suchlauf mit kontinuierlicher Änderung der Suchfrequenz durchzuführen.

Vorzugsweise ist der Funkempfänger auch dazu eingerichtet, das Empfangsbereitschafts-Zeitintervall zu beenden, nachdem er einen erfolgreichen Empfang des erwarteten Funktelegramms von einem betreffenden Sender etwa anhand einer Endkennung des Funksignals erfasst hat.

Da sich die HF-Quarzfrequenz des Funksenders nicht sprunghaft verändern wird, sondern bei einer meist nur langsamen Temperaturänderung ein näherungsweise zeitlineares Verhalten zeigt, ist der Zusammenhang zwischen dem Zeitabstand seit dem letzten Funkempfangsereignis und der Änderung der Senderfrequenz zumindest näherungsweise linear, wohingegen der Zusammenhang zwischen der Abweichung des Sendezeitpunktes von seinem Nominalwert und dem tatsächlichen Zeitabstand des aktuellen Sendeereignisses vom letzten Sendeereignis dagegen als integral über die Taktgeberfrequenz des Funksenders zumindest näherungsweise quadratisch ist. Der (akkumulierte) Zeitfehler seit dem letzten Funktelegrammempfang wird daher (als Mittelwert über die zeitlich linear angenommene Frequenzänderung) nur gerade der Hälfte des Zeitfehlers entsprechen, der sich aus dem Produkt aus Frequenzänderung und Zeitabstand seit dem letzten Empfang ergeben würde. Dies wird bei einer bevorzugten Ausführungsform der Erfindung von der Empfangssteuerschaltung des Empfängers berücksichtigt.

Die Möglichkeit der Ausnutzung der Frequenz des Trägerfrequenzgebers, also der HF-Quarzfrequenz als Referenztaktmaß für die Zeiterfassung in dem Funksender wird bei einer weiteren Ausführungsform des Funkübertragungssystems nach der Erfindung in folgender Weise genutzt. Der Zeitgeber des Funksenders hat einen eigenen Taktgeber, normalerweise einen handelsüblichen Uhrenquarz, wobei der Zeitgeber dazu eingerichtet ist, die mittels der Zeitmessmittel durch Zeitakkumulation der Takte des Taktgebers bestimmten Zeiten nach Maßgabe eines Referenzzeitmaßes oder eines Referenztaktmaßes zu korrigieren, welches von der Frequenz des Trägerfrequenzgebers abgeleitet ist. Die letztgenannte Lösung findet vorzugsweise bei Funksendern mit Batteriebetrieb Anwendung.

Da die Uhrzeitoszillatorschaltung (Uhrzeittaktgeber) des Funksenders während der gesamten Batterielebensdauer aktiv sein muss, ist ein extrem stromsparender Quarzoszillator erforderlich. Als Uhrzeit-Taktgeber haben sich die von Quarzarmbanduhren her bekannten Stimmgabelquarze mit einer Nennfrequenz von 32768 Hz durchgesetzt. Ihr Dauerstromverbrauch liegt im Bereich weniger μA, wodurch die gewünschten Batterielebensdauern von über 10 Jahren ermöglicht werden. Höherfrequente Quarzoszillatoren mit Schwingquarzen mit MHz-Bereich haben deutlich höheren Strombedarf, so z.B. auch der HF-Trägerfrequenzgeber des Funksenders. Bei der Ausführungsform der Erfindung mit Zeitkorrektur auf der Basis eines Referenzzeitmaßes vom Trägerfrequenzgeber ist es im Hinblick auf den Strombedarf sinnvoll, den Trägerfrequenzgeber nur dann zu aktivieren, wenn es unbedingt erforderlich ist, also etwa zu den Sendezeitpunkten. Demgemäß ist es bei einer solchen Ausgestaltung der Erfindung vorgesehen, dass der Funksender den Trägerfrequenzgeber in Zeitabständen für kurze Aktivierungsphasen (z.B. Sendephasen) betreibt und während der kurzen Aktivierungsphasen die Frequenz, die Periodendauer oder eine daraus ableitbare Größe des Funksender-Taktgebers als ein Taktmaß des Zeitgebers auf der Basis eines vom Trägerfrequenzgeber abgeleiteten Vergleichszeitmaßes zu erfassen und bei Abweichung des erfassten Taktmaßes von einem Sollwert die mittels der Zeitmessmittel akkumulierte Zeit in Abhängigkeit vom Maß der Abweichung zu korrigieren.

Dies kann z.B. dadurch erfolgen, dass der Funksender über die Zeitdauer einer vorbestimmten Anzahl von Takten des Funksender-Taktgebers die Anzahl der Takte des Trägerfrequenzgebers zählt, die Taktzahlabweichung zwischen dem Zählergebnis und einem Sollwert ermittelt und die mittels der Zeitmessmittel akkumulierte Zeit in Abhängigkeit von der Taktzahldifferenz korrigiert.

Eine alternative Korrekturmöglichkeit besteht darin, dass der Funksender während der kurzen Aktivierungsphasen des Trägerfrequenzgebers die Frequenz des Uhrzeit-Taktgebers innerhalb eines einer bestimmten Anzahl der Takte des Trägerfrequenzgebers entsprechenden Zeitintervalls misst, die Abweichung des Frequenzmesswertes von einem Sollwert ermittelt und die mittels der Zeitmessmittel akkumulierte Zeit in Abhängigkeit von der Abweichung korrigiert.

Hinsichtlich der Zeitgenauigkeit betreffend die Zeitintervalle aufeinander folgender Sendeereignisse stellt sich der Funksender für den Funkempfänger bei den vorstehend diskutierten Lösungen zumindest näherungsweise so dar, wie wenn der Zeitgeber des Funksenders seinen Zeittakt unmittelbar von dem Trägerfrequenzgeber dauerhaft erhielte. Es ist somit wiederum die Verknüpfung zwischen dem die Sendefrequenz bestimmenden Trägerfrequenzgeber und dem Zeitgeber des Funksenders verwirklicht, die zur Optimierung des automatischen Funkempfangsfrequenz-Suchlaufs des Funkempfängers erforderlich ist.

Gemäß einer Ausführungsform der Erfindung kann der Funkempfänger dazu eingerichtet sein, die maximalen Empfangsbereitschafts-Zeitintervalle stets gleich lang zu halten.

Vorzugsweise wird jedoch eine Lösung angewandt, bei der die Empfangssteuerschaltung des Funkempfängers dazu eingerichtet ist, die maximale Dauer des jeweiligen Empfangsbereitschafts-Zeitintervalls für den Empfang eines erwarteten nächsten Funktelegramms von dem betreffenden Funksender in Abhängigkeit von dem Zeitabstand vom letzten erfolgreichen Empfang eines Funktelegramms von dem Sender bis zum erwarteten Empfang des nächsten Funktelegramms festzulegen, und zwar im Sinne einer Verlängerung der maximalen Dauer des Empfangsbereitschafts-Zeitintervalls bei Vergrößerung des Zeitabstandes. Hierzu kann ein in der EP 1 028 403 A2 schon offenbartes Prinzip der Einstellung der Empfangsbereitschafts-Zeitintervalle genutzt werden.

Für die Suchlaufsteuerung wird ferner vorgeschlagen, dass die Empfangssteuerschaltung des Funkempfängers dazu eingerichtet ist, die Suchlaufstartfrequenz und den maximalen Suchlauffrequenzbereich für den jeweils nächsten Funkempfangsfrequenz-Suchlauf in Abhängigkeit von dem Zeitabstand vom letzten erfolgreichen Empfang eines Funktelegramms bis zum erwarteten Empfang des nächsten Funktelegramms von dem betreffenden Sender festzulegen. Bei sehr großem Zeitabstand zwischen den Sendeereignissen bzw. Empfangsereignissen wird der Suchlauffrequenzbereich größer sein als bei einem kleinen Zeitabstand, da sich die Senderfrequenz über den größeren Zeitabstand stärker geändert haben könnte, was sich auch unmittelbar auf den Zeitfehler auswirkt. Dementsprechend wird auch das Empfangsbereitschafts-Zeitintervall bei dem größeren Zeitabstand länger sein.

Vorzugsweise ist das Funkübertragungssystem in ein Verbrauchsdaten-Erfassungssystem integriert, wobei der Funksender Element eines Verbrauchsmessgerätes, insbesondere eines elektronischen Heizkostenverteilers, eines Wasserzählers, eines Gaszählers, eines Wärmemengenzählers oder eines Stromzählers ist und dazu dient, Messdaten des Verbrauchsmessgerätes in Funktelegrammen an den Funkempfänger zu senden.

Die Erfindung wird im Folgenden anhand der Figuren näher erläutert.

Fig. 1  zeigt schematisch ein Funkübertragungssystem nach der Erfindung.

Fig. 2  zeigt ein Zeitdiagramm zur Erläuterung des Funkbetriebs des Funkübertragungssystems nach Fig. 1.

Fig. 3  zeigt ein Zeitdiagramm zur Erläuterung eines Empfangsfrequenz-Suchlaufs des Empfängers des Funkübertragungssystems.

Fig. 4  zeigt ein Zeitdiagramm zur Erläuterung einer Zeitkorrektur des Zeitgebers des Funksenders für ein spezielles Ausführungsform der Erfindung.

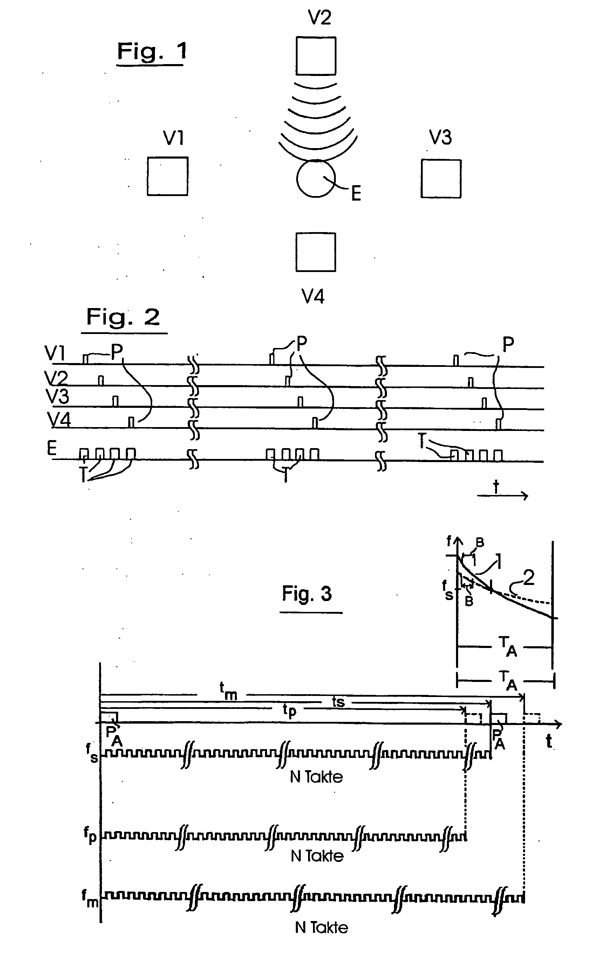

Fig. 1 zeigt schematisch ein Funkübertragungssystem, welches z.B. in ein Verbrauchserfassungssystem mit Verbrauchsmessgeräten V1 - V4 integriert ist, wobei die Verbrauchsmessgeräte V1 - V4 in der Lage sind, ihren Zählerstand und ihre Zählernummer (identifikationsinformation) per Funk zu einem Empfänger E unidirektional zu übertragen. Bei den Verbrauchsmessgeräten V1 - V4 kann es sich z.B. um Heizkostenverteiler in verschiedenen Wohnungen eines Hauses handeln, wobei der Empfänger E z.B. im gemeinsamen Treppenhaus vorgesehen ist, so dass die im Empfänger E gespeicherten Informationen über die Zählerstände der Verbrauchsmessgeräte V1 - V4 ggf. von einer autorisierten Person ausgelesen werden können, ohne dass diese Person die Wohnungen zu betreten hat, in denen die Verbrauchsmessgeräte V1 - V4 installiert sind. Denkbar ist auch, dass der Empfänger seine Informationen drahtgebunden oder z.B. über ein Mobilfunksystem an eine Zentrale weitersendet.

Die Geräte V1 - V4 senden ihre Funktelegramme zu bestimmten jedoch unterschiedlichen Zeiten zum Empfänger E.

In Fig. 2 sind in einem Zeitdiagramm die Sendezeitintervalle der Verbrauchsmessgeräte V1 - V4 schematisch durch Rechteckimpulse P angedeutet. Der Empfänger E enthält eine möglichst genau gehende Uhr sowie Informationen über die Sendezeiten der Geräte V1 - V4 und ist so gesteuert, dass er die ebenfalls in Fig. 2 angedeuteten Zeitfenster T für den Funkempfang öffnet, wobei diese Zeitfenster T so bemessen sind, dass sie mit einem jeweiligen Sendeereignis P der Verbrauchszähler V1 - V4 zeitlich zusammenfallen. Zwischen aufeinander folgenden Funktelegrammen eines Gerätes V1 - V4 kann eine lange Pause von mehreren Stunden Dauer liegen.

In Fig. 3 ist mit $t_s$ ein solcher Zeitabstand zwischen den Startpunkten zweier aufeinander folgender Funktelegramme $P_A$ eines Verbrauchsmessgerätes V1 .... V4 eingezeichnet, wobei angenommen worden ist, dass der die Sendezeitabstände bestimmende Zeitgeber des betreffenden Verbrauchsmessgerätes V seine Zeittaktfrequenz $f_s$ seit dem Empfang des vorausgegangenen Sendeereignisses (hier im Ursprung des Zeitdiagramms) nicht geändert hat. Das Zeittaktsignal $f_s$ ist in Fig. 3 (nicht maßstäblich) als Rechteckimpulssignal dargestellt.

$f_p$ zeigt in Fig. 3 das Zeittaktsignal für den Fall, dass sich die Frequenz des Zeittakt bestimmenden Elementes im Vergleich mit $f_s$ (im Beispielsfall sprunghaft) vergrößert hat.

$f_m$ zeigt das Zeittaktsignal für den Fall, dass sich die Frequenz des Zeittakt bestimmenden Elementes des Funksenders seit dem vorausgegangenen Sendeereignis (im Beispielsfall sprunghaft) vermindert hat.

Da die Zeitmessung in dem Funksender des betreffenden Verbrauchsmessgerätes V auf der Basis der Zeitakkumulation der Zeittaktimpulse folgt, beginnt der Sender mit der jeweils nächsten Funktelegrammübertragung, nachdem sein Zähler eine vorbestimmte Anzahl N an Zeittakten gezählt hat.

Im Falle der angestiegenen Frequenz $f_p$ bedeutet dies, dass der Zeitabstand $t_p$ zwischen den aufeinander folgenden Sendeereignissen $P_A$ kleiner geworden ist im Vergleich mit $t_s$.

Für den Fall der verminderten Frequenz $f_m$ ist der Zeitabstand $t_m$ zwischen aufeinander folgenden Sendeereignissen größer als $t_s$, d.h. der Taktzähler des Senders benötigt eine etwas längere Zeit zur Akkumulation der betreffenden Anzahl an Zeittakten. Dies macht unmittelbar deutlich, dass Frequenzschwankungen des Zeittaktgebers des Funksenders eine Zeitunsicherheit im Hinblick auf die jeweiligen Sendezeitpunkte zur Folge haben.

Für den Empfänger bedeutet dies, dass er über ein Toleranzzeitintervall $T_A$ empfangsbereit geschaltet sein muss, damit er das erwartete Funktelegramm $P_A$ mit großer Wahrscheinlichkeit empfangen kann. Sobald der Empfänger das Funktelegramm innerhalb des Zeitfensters $T_A$ vollständig empfangen hat, kann er unmittelbar wieder in den Passivzustand übergehen, bis das nächste Funktelegramm erwartet wird. Die Empfangsbereitschaftszeiten sind daher üblicherweise kürzer, als es den kalkulierten Maximalwerten für $T_A$ entspricht.

Bei den jeweiligen Funksendern in den Geräten V1 - V4 dient eine vom Trägerfrequenz-Taktgeber abgeleitete Frequenz als Referenztaktmaß, so dass zwischen den Sendefrequenzen und den Sendezeiten eine Beziehung besteht. Sendet der betreffende Funksender sein Funktelegramm früher als erwartet, also etwa nach der Zeit $t_p$ gemäß Fig. 3

(die Senderuhr geht vor), so bedeutet dies, dass auch die Sendefrequenz zugenommen hat. Sendet der Funksender das Funktelegramm jedoch später als erwartet, etwa zum Zeitpunkt $t_m$ gemäß Fig. 3 (die Senderuhr geht nach), so bedeutet dies, dass die Trägerfrequenz des Senders seit dem vorausgegangenen Sendeereignis kleiner geworden ist. In Fig. 3 ist im oberen rechten Bereich ein Sendefrequenz-Zeitdiagramm für Sendezeitpunkte, die innerhalb des Empfangsbereitschafts-Zeitintervalls des Funkempfängers liegen, dargestellt. Die in Fig. 3 angedeuteten Zeitmaße beziehen sich auf das Zeitsystem des Empfängers, wobei vorausgesetzt worden ist, dass der Empfänger eine erheblich genauer gehende Uhr aufweist als der Sender.

Der Empfänger ist nun dazu eingerichtet, einen automatischen Funkempfangsfrequenz-Suchlauf in dem jeweiligen Empfangsbereitschafts-Zeitintervall $T_A$ durchzuführen, wobei er den Empfangsfrequenz-Suchlauf zu Beginn des Zeitfensters $T_A$ mit einer höheren Frequenzeinstellung bei gegebener Suchbandbreite B startet und dann mit abnehmender Suchfrequenz und vorzugsweise gleichbleibender Bandbreite B fortsetzt. In dem Frequenz-Zeit-Teildiagramm in Fig. 3 ist mit durchgezogener Linie 1 ein Frequenz-Zeit-Zusammenhang angedeutet, wie er z.B. in dem Fall vorliegen könnte, dass sich die Trägerfrequenz des Senders mit dem vorausgegangenen Sendeereignis sprunghaft geändert hat. Der Empfänger kann zur Berücksichtigung dieses Extremfalls der Frequenzänderung dazu eingerichtet sein, mit einer hinreichend großen Suchbandbreite B dem Frequenzverlauf gemäß Kurve 1 in Fig. 3 beim Empfangsfrequenz-Suchlauf zu folgen, bis er den erfolgreichen Empfang des erwarteten Funktelegramms registriert, um dann die Empfangsfrequenz für den Empfang des Funktelegramms beizubehalten.

Mit gestrichelter Linie 2 ist in dem Frequenz-Zeit-Teildiagramm in Fig. 3 ein Beispiel für den jeweiligen Fall angedeutet, dass sich die Trägerfrequenz des Senders seit dem vorausgegangenen Sendeereignis nicht sprunghaft, sondern zeitlich linear geändert hat. Dies ist eine in den meisten Anwendungsfällen durchaus realistische Annahme. Dabei ist der Zusammenhang zwischen der Änderung des Sendezeitpunktes von seinem Nominalwert und der Zeit seit dem letzten Empfang dagegen als integral über die Taktgeberfrequenz näherungsweise quadratisch. Der (akkumulierte) Zeitfehler seit dem letzten Funktelegrammempfang wird daher als Mittelwert über die zeitlich linear angenommene Frequenzänderung nur gerade der Hälfte des Zeitfehlers entsprechen, der sich aus dem Produkt aus Frequenzänderung und Zeit seit dem vorausgegangenen Empfangsereignis ergeben würde. Vorzugsweise ist der Empfänger dazu eingerichtet, bei seinem Funkempfangsfrequenz-Suchlauf einer Frequenzkurve zu folgen, bei der die Frequenz-Zeitzusammenhänge für den Fall linearer Frequenzänderungen berücksichtigt sind, also im Beispielsfall der Kurve 2 in Fig. 3.

Bei den bisherigen Betrachtungen im Zusammenhang mit den Fig. 1 - 3 wurde vorausgesetzt, dass die Funksender jeweils einen gemeinsamen Taktgeber für die Zeiterfassung und für die Trägerfrequenzbereitstellung aufweisen und nutzen. Eine solche Lösung ist für Funkkomponenten ideal, die am Stromnetz angeschlossen sind. Für die überwiegende Anzahl batteriebetriebener Sender lässt sie sich jedoch nicht realisieren. Diese haben üblicherweise einen handelsüblichen Uhrenquarz als Zeitbasis für die Sendezeitvorgabe. Der die HF-Sendefrequenz bestimmende Senderquarz wird bei solchen Sendern üblicherweise nur zu den jeweiligen Sendeereignissen aktiv geschaltet. Gemäß einem Ausführungsbeispiel der vorliegenden Erfindung wird die Frequenz des Uhrenquarzes mit der Frequenz des Trägerfrequenzgeberoszillators verglichen und aus der Abweichung und dem Zeitabstand zwischen den Frequenzvergleichen eine Zeitkorrektur errechnet, um die senderinterne Zeitabweichung zu korrigieren, so dass bei einer Veränderung der Sendefrequenz die Zeitdifferenz zwischen Sendeereignissen sich zumindest näherungsweise so verändert, als wäre der Trägerfrequenzgeberoszillator (Sendequarz) die effektive Taktbasis für die Sendezeitbestimmung.

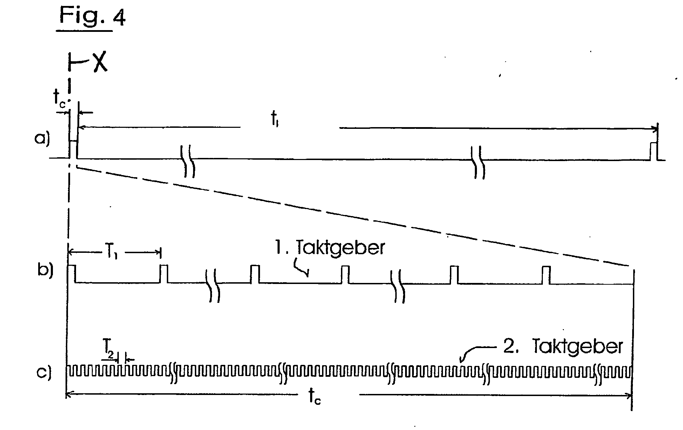

Zur Erläuterung des Zeitkorrekturbetriebs wird nachstehend auf Fig. 4 Bezug genommen. Es sei an dieser Stelle darauf hingewiesen, dass die Taktverläufe in Fig. 4 nicht zeitmaßstabsgerecht sind. Fig. 4 zeigt in dem Zeitdiagramm a) einen Zeitabschnitt $t_i$ zwischen zwei aufeinander folgenden Zeitkorrekturereignissen. Es sei der Einfachheit halber angenommen, dass jedes Mal nach Ablauf eines Zeitintervalls $t_i$ erneut eine Korrekturoperation durchgeführt wird. Es sei für den Beispielsfall ferner angenommen, dass das Zeitintervall $t_i$ 1024 s $\cong$ 17 min betragen soll, und zwar entsprechend der Zeiterfassung durch eine Zeitakkumulatorschaltung, die von einem Uhrenquarz getaktet wird. Es sei ferner angenommen, dass der Uhrenquarz (1. Taktgeber) eine Nennfrequenz von 32768 Hz hat und dass die stabile Frequenz des als 2. Taktgeber bezeichneten HF-Quarzes, von dem auch die Sendefrequenz abgeleitet wird, 4 MHz beträgt.

Die Zeitakkumulatorschaltung gibt zu den in Diagramm a) der Fig. 4 mit X gekennzeichneten Zeitpunkten ein Wecksignal an den Mikrocontroller des Senders ab, um ihn dazu zu veranlassen, ein Zählprogramm auszuführen und entsprechend diesem Zählprogramm eine vorbestimmte Anzahl von Takten $T_1$ (vgl. Diagramm b) in Fig. 4) zu zählen. Im Beispielsfall seien dies exakt 8192 Takte. Für den Fall, dass der Uhrenquarz stabil mit seiner Nennfrequenz von 32768 Hz schwingen sollte, so dauerten die 8192 Takte exakt 250 ms. Die Dauer der Abzählung von 8192 Takten des ersten Taktgebers ist in Fig. 4 im Diagramm a) mit $t_c$ bezeichnet.

Für die folgenden Betrachtungen bedeutet $t_{csoll}$ die Zeit $t_c$ für den Fall des korrekten Uhrenganges entsprechend der Nennfrequenz des Uhrenquarzes. Wie schon angesprochen, beträgt $t_{csoll}$ im Beispielsfall 250 ms. $t_{cist}$ steht für die tatsächliche Dauer von 8192 Perioden des üblicherweise nicht exakt mit seiner Nennfrequenz schwingenden Uhrenquarzes 2.

Die Auszählung der 8192 Perioden dient dazu, ein Zeitintervall vorzusehen, in dem der Mikrocontroller die

Anzahl der Takte $T_2$ des Zeittaktgebers mit stabiler Frequenz zählt.

Bei korrektem Uhrengang der Zeitakkumulatorschaltung würden in das 250 ms-Zeitintervall $t_{cist}$ exakt $1 \times 10^6$ Takte $T_2$ passen. In dem realistischeren Fall, dass der Uhrenquarz mit einer von seiner Nennfrequenz abweichenden Frequenz schwingt und $t_{cist}$ somit vom Sollwert $t_{csoll} = 250$ ms abweichen wird, ergibt sich auch bei der Zählung der Takte $T_2$ innerhalb des sich durch die 8192 Takte $T_1$ ergebenden Zeitintervalls $t_{cist}$ ein von $n_{2soll} = 1 \times 10^6$ abweichender Zählwert $n_{2ist}$.

Mit

$$n_{2soll} \times T_2 = t_{csoll}$$

$$n_{2ist} \times T_2 = t_{cist}$$

mit $T_2$ als Periodendauer des Signals des zweiten Taktgebers ergibt sich für den relativen Zeitfehler:

$$\Delta t_{rel} = (t_{cist} - t_{csoll}) / t_{cist} = (n_{2ist} - n_{2soll}) / n_{2ist} = (1 - n_{2soll} / n_{2ist}).$$

Auf das gesamte Zeitintervall $t_i$ zwischen zwei Korrekturereignissen angewandt, beträgt der absolute Zeitfehler:

$$\Delta t = \Delta t_{rel} \times t_i = (1 - n_{2soll} / n_{2ist}) \times t_i.$$

Je nachdem, ob der relative Zeitfehler negativ ist ($n_{2ist} > n_{2soll}$ - die Uhr geht nach) oder ob der relative Fehler negativ ist ($n_{2ist} < n_{2soll}$ - die Uhr geht vor), sind der Zeitakkumulatorschaltung zur Zeitkorrektur rechnerisch Zeittakte zum Zählstand zuzuaddieren oder vom Zählstand abzuziehen. Diese Zähl- und Rechenfunktionen werden von dem Mikrocontroller ausgeführt bzw. von diesem kontrolliert.

Für den Fall, dass der Uhrenquarz mit einer konstanten Abweichung von seiner Nennfrequenz schwingen sollte, lässt sich die Anzahl der Takte zur Berichtigung der Zeitakkumulation $n_x$ wie folgt berechnen:

$$n_x = t_i \times (1 - n_{2soll} / n_{2ist}) / T_1,$$

worin $T_1$ die Nennperiodendauer der Takte des Uhrenquarzes bezeichnet.

In dem Beispielsfall mit $t_{csoll} = 250$ ms und $n_{2soll} = 1 \times 10^6$ bedeutet eine Abweichung von +/- 1 im Zählergebnis $n_{2ist}$ vom Sollwert $n_{2soll}$ einen relativen Fehler von 1 ppm.

Entsprechend dem Zeitabstand $t_i$ zwischen zwei Korrekturoperationen von 1024 Sekunden ergibt sich für den absoluten Zeitfehler der Wert 1,024 ms und somit für die Anzahl der Takte zur Berichtigung der Zeitakkumulation der Wert $n_x = +/- 33$ Takte $T_1$. Dies bedeutet, dass für jeden innerhalb der Zeitdauer von 8192 Takten $T_1$ über den Sollwert hinausgehend gezählten Takt des zweiten Zeittaktgebers die akkumulierte Uhrzeit um 33 Takte $T_1$ vorgestellt werden muss, d.h., dass 33 Takte zu dem Zeitzählerstand der Zeitakkumulatorschaltung hinzuaddiert werden müssen. Nach einer jeweiligen Korrekturoperation kann der Mikrocontroller wieder in den Pausenzustand übergehen.

Für das vorstehend genannte Beispiel wurde die idealisierende Annahme gemacht, dass die Frequenz des ersten Zeittaktgebers, also des Uhrenquarzes, innerhalb des Zeitabstandes $t_i$ zwischen zwei Korrekturoperationen nicht driftet, sondern nur eine konstante Abweichung vom Nennwert aufweist.

Realistischer ist die Annahme, dass sich die Frequenz über den Zeitabstand $t_i$ zwischen zwei Korrekturoperationen näherungsweise linear mit der Zeit ändert. In diesem Fall ist der Zusammenhang zwischen der Änderung der akkumulierten Zeit als Integral über die Takte $T_1$ quadratisch. Der (akkumulierte) Zeitfehler seit der letzten Zeitkorrekturoperation wird daher (als Mittelwert über eine zeitlich linear angenommene) Frequenzänderung nur gerade der Hälfte des Zeitfehlers entsprechen, der sich aus der obigen Betrachtung konstanter Frequenzabweichung ergeben würde. Für das vorstehend erläuterte Beispiel bedeutet dies, dass der Wert der Zeitkorrektur $n_x$ zu vermindern, insbesondere zu halbieren ist, so dass in dem Beispiel pro mehr gezähltem HF-Takt $T_2$ nur 16-17 Takte $T_1$ zum Zeitakkumulatorstand zu addieren sind und pro zu wenig gezähltem HF-Takt $T_2$ 16-17 Takte $T_1$ vom Zeitakkumulatorstand zu subtrahieren sind.

Die von dem Uhrzeitquarz und der Zeitakkumulatorschaltung erfasste Uhrzeit wird somit bei jeder Korrekturoperation bedarfsweise berichtigt, so dass der verbleibende Zeitfehler der Schaltungsanordnung mit Frequenzänderungen des Trägerfrequenzgebers (2. Taktgeber) zusammenhängen.

Es sei darauf hingewiesen, dass bei dem Funkübertragungssystem nach der Erfindung ein Verfahren der Sendezeitabschätzung zum Zwecke der Minimierung der jeweiligen Empfangsbereitschafts-Zeitintervalle Anwendung finden kann, wie es in der EP 1 028 403 A2 erläutert ist.

**Patentansprüche**

1. Funkübertragungssystem mit wenigstens einem Funksender (V), der eine Sendesteuerschaltung aufweist und dazu eingerichtet ist, nach einem bestimmten Sendezeitschema Funktelegramme in Zeitintervallen mit dazwischen liegenden Pausen zu senden, und mit wenigstens einem Funkempfänger (E) der eine Empfangssteuerschaltung umfasst, die dazu eingerichtet ist, den Funkempfänger (E) nach Maßgabe des Sendezeitschemas für die Dauer jeweiliger Empfangsbereitschaflszeitintervalle ($T_A$) empfangsbereit zu schalten, um Funktelegramme von dem Funksender (V) zu empfangen, wobei der Funksender (V) einen Zeitgeber mit Zeitmessmitteln zur Bestimmung der Sendezeitpunkte und einen Trägerfrequenzgeber zur Bereitstellung der Funksendefrequenz umfasst, **dadurch gekennzeichnet, dass** die vom Zeitgeber des Funksenders (V) vorgegebene Zeit von der Frequenz des Trägerfrequenzgebers als Referenztaktmaß abhängig ist und dass der Funkempfänger (E) dazu eingerichtet ist, in einer Suchlauf-Betriebsart, einen automatischen Funkempfangsfrequenz-Suchlauf mit abnehmender Funkempfangssuchfrequenz in den Empfangsbereitschaftszeitintervallen ($T_A$) durchzuführen, um die Funkempfangsfrequenz des Funkempfängers (E) auf die Funksendefrequenz des Funksenders (V) abzustimmen.

2. Funkübertragungssystem nach Anspruch 1, **dadurch gekennzeichnet, dass** der Zeitgeber des Funksenders (V) seinen Zeittakt von dem Trägerfrequenzgeber erhält.

3. Funkübertragungssystem nach Anspruch 1, **dadurch gekennzeichnet, dass** der Zeitgeber des Funksenders (V) einen eigenen Taktgeber umfasst und dazu eingerichtet ist, die mittels der Zeitmessmittel durch Zeitakkumulation der Takte des Taktgebers bestimmten Zeiten nach Maßgabe eines Referenzzeitmaßes oder eines Referenztaktmaßes zu korrigieren, welches von der Frequenz des Trägerfrequenzgebers abgeleitet ist.

4. Funkübertragungssystem nach Anspruch 3, **dadurch gekennzeichnet, dass** der Funksender (V) dazu eingerichtet ist,

   a) den Trägerfrequenzgeber in Zeitabständen für kurze Aktivierungsphasen zu betreiben,
   b) während der kurzen Aktivierungsphasen die Frequenz, die Periodendauer oder eine daraus ableitbare Größe des Funksender-Taktgebers als ein Taktmaß des Zeitgebers auf der Basis eines vom Trägerfrequenzgeber abgeleiteten Vergleichszeitmaßes zu erfassen und
   c) bei Abweichung des erfassten Taktmaßes von einem Sollwert die mittels der Zeitmessmittel akkumulierte Zeit in Abhängigkeit vom Maß der Abweichung zu korrigieren.

5. Funkübertragungssystem nach Anspruch 4, **dadurch gekennzeichnet, dass** der Funksender (V) dazu eingerichtet ist,

   - über die Zeitdauer einer vorbestimmten Anzahl von Takten ($T_1$) des Funksender-Taktgebers die Anzahl der Takte ($T_2$) des Trägerfrequenzgebers zu zählen,
   - die Taktzahlabweichung zwischen dem Zählergebnis und einem Sollwert zu ermitteln und
   - die mittels der Zeitmessmittel akkumulierte Zeit in Abhängigkeit von der Taktzahldifferenz zu korrigieren.

6. Funkübertragungssystem nach Anspruch 4, **dadurch gekennzeichnet, dass** der Funksender (V) dazu eingerichtet ist,

   - während der kurzen Aktivierungsphasen des Trägerfrequenzgebers die Frequenz des Taktgebers innerhalb eines einer bestimmten Anzahl der Takte des Trägerfrequenzgebers entsprechenden Zeitintervalls zu messen,
   - die Abweichung des Frequenzmesswertes von einem Sollwert zu ermitteln und

- die mittels der Zeitmessmittel akkumulierte Zeit in Abhängigkeit von der Abweichung zu korrigieren.

7. Funkübertragungssystem nach einem der vorhergehenden Ansprüche, **dadurch gekennzeichnet, dass** die Empfangssteuerschaltung dazu eingerichtet ist, auf der Basis von Sollwerten für die Zeitabstände aufeinanderfolgender Funktelegramme ($P_A$) des betreffenden Funksenders (V1-V4) den jeweiligen Zeitpunkt der erwarteten nächstfolgenden Funktelegrammsendung des Funksenders (V) abzuschätzen und den Funkempfänger (E) zeitweilig jeweils in einem Empfangsbereitschaftszeitintervall ($T_A$), das den geschätzten Zeitpunkt enthält, empfangsbereit zu schalten, um das Funktelegramm ($P_A$) zu empfangen.

8. Funkübertragungssystem nach einem der vorhergehenden Ansprüche, **dadurch gekennzeichnet, dass** die Empfangssteuerschaltung dazu eingerichtet ist, die maximale Dauer des jeweiligen Empfangsbereitschaftszeitintervalls ($T_A$) für den Empfang eines erwarteten nächsten Funktelegramms ($P_A$) von dem betreffenden Funksender (V1-V4) in Abhängigkeit von dem Zeitabstand vom letzten erfolgreichen Empfang eines Funktelegramms ($T_A$) von dem Sender (V) bis zum erwarteten Empfang des nächsten Funktelegramms festzulegen, und zwar im Sinne einer Verlängerung der maximalen Dauer des Empfangsbereitschaftszeitintervalls ($T_A$) bei Vergrößerung des Zeitabstandes.

9. Funkübertragungssystem nach einem der vorhergehenden Ansprüche, **dadurch gekennzeichnet, dass** die Empfangssteuerschaltung dazu eingerichtet ist, den automatischen Funkempfangsfrequenz-Suchlauf mit kontinuierlicher Abnahme der Funkempfangssuchfrequenz durchzuführen.

10. Funkübertragungssystem nach einem der vorhergehenden Ansprüche, **dadurch gekennzeichnet, dass** die Empfangssteuerschaltung dazu eingerichtet ist, die Suchlaufstartfrequenz und den maximalen Suchlauffrequenzbereich für den jeweils nächsten Funkempfangsfrequenz-Suchlauf in Abhängigkeit von dem Zeitabstand vom letzten erfolgreichen Empfang eines Funktelegramms ($P_A$) bis zum erwarteten Empfang des nächsten Funktelegramms ($P_A$) von dem betreffenden Sender (V1-V4) festzulegen.

11. Funkübertragungssystem nach einem der vorhergehenden Ansprüche, **dadurch gekennzeichnet, dass** der Funksender Element eines Messgerätes (V1-V4) ist, wobei er dazu eingerichtet ist, Messdaten des Messgerätes in Funktelegrammen ($P_A$) an den Funkempfänger (E) zu senden.

12. Funksystem nach Anspruch 11, **dadurch gekennzeichnet, dass** das Messgerät ein Verbrauchsmessgerät ist.

13. Funksystem nach Anspruch 12, **dadurch gekennzeichnet, dass** das Verbrauchsmessgerät ein elektronischer Heizkostenverteiler, Wasserzähler, Gaszähler, Wärmemengenzähler oder Stromzähler ist.


**Claims**

1. Radio transmission system with at least one radio transmitter (V) which has a transmitting control circuit and is adapted to send radiotelegrams in time intervals with pauses in between according to a certain transmission time diagram, and with at least one radio receiver (E) which comprises a receiving control circuit which is adapted to switch the radio receiver (E) into ready-to-receive mode for the duration of each respective ready-to-receive time interval ($T_A$) according to the transmission time diagram in order to receive radiotelegrams from the radio transmitter (V), wherein the radio transmitter (V) comprises a timer with time measuring means for determining the transmission instants and a carrier frequency generator for providing the radio transmitting frequency, **characterised in that** the time predetermined by the timer of the radio transmitter (V) is dependent on the frequency of the carrier frequency generator as reference clock value, and that the radio receiver (E) is adapted to carry out, in a search mode, an automatic radio receiving frequency search with a decreasing radio receiving search frequency in the ready-to-receive time intervals ($T_A$) in order to tune the radio receiving frequency of the radio receiver (E) to the radio transmitting frequency of the radio transmitter (V).

2. Radio transmission system according to Claim 1, **characterised in that** the timer of the radio transmitter (V) receives its timing clock from the carrier frequency generator.

3. Radio transmission system according to Claim 1, **characterised in that** the timer of the radio transmitter (V) comprises its own timing generator and is adapted to correct the times determined by means of the time measuring means through time accumulation of the clock pulses of the timing generator according to a reference time value or a reference clock value which is derived from the frequency of the carrier frequency generator.

4. Radio transmission system according to Claim 3, **characterised in that** the radio transmitter (V) is adapted

   a) to operate the carrier frequency generator in time intervals for short activation phases,
   d) to acquire during the short activation phases the frequency, the period or a quantity of the radio transmitter timing generator derivable therefrom as a clock value of the timer on the basis of a comparison time value derived from the carrier frequency generator and,
   c) if the acquired clock value deviates from a desired value, to correct the time accumulated by means of the time measuring means in accordance with the extent of the deviation.

5. Radio transmission system according to Claim 4, **characterised in that** the radio transmitter (V) is adapted

   - to count the number of clock pulses ($T_2$) of the carrier frequency generator over the duration of a predetermined number of clock pulses ($T_1$) of the radio transmitter timing generator,
   - to establish the deviation in the number of clock pulses between the counter result and a desired value and
   - to correct the time accumulated by means of the time measuring means in accordance with the difference in the number of clock pulses.

6. Radio transmission system according to Claim 4, **characterised in that** the radio transmitter (V) is adapted

   - to measure the frequency of the timing generator within a time interval corresponding to a certain number of clock pulses of the carrier frequency generator during the short activation phases of the carrier frequency generator,
   - to establish the deviation of the measured frequency value from a desired value and
   - to correct the time accumulated by means of the time measuring means in accordance with the deviation.

7. Radio transmission system according to any one of the preceding Claims, **characterised in that** the receiving control circuit is adapted to estimate the respective instant of the anticipated next following radiotelegram transmission of the radio transmitter (V) on the basis of desired values for the time intervals of consecutive radiotelegrams ($P_A$) of the radio transmitter (V1-V4) concerned and to temporarily switch the radio receiver (E) into ready-to-receive mode in each case in a ready-to-receive time interval ($T_A$) containing the estimated instant in order to receive the radiotelegram ($P_A$).

8. Radio transmission system according to any one of the preceding Claims, **characterised in that** the receiving control circuit is adapted to establish the maximum duration of the respective ready-to-receive time interval ($T_A$) for receiving an anticipated next radiotelegram ($P_A$) from the radio transmitter (V1-V4) concerned in accordance with the time interval from the last successful reception of a radiotelegram ($P_A$) from the transmitter (V) to the anticipated reception of the next radiotelegram, namely in the sense of an extension of the maximum duration of the ready-to-receive time interval ($T_A$) while increasing the time interval.

9. Radio transmission system according to any one of the preceding Claims, **characterised in that** the receiving control circuit is adapted to carry out the automatic radio receiving frequency search with a continuous decrease in the radio receiving search frequency.

10. Radio transmission system according to any one of the preceding Claims, **characterised in that** the receiving control circuit is adapted to establish the search-start frequency and the maximum search frequency range for the respective next radio receiving frequency search in accordance with the time interval from the last successful reception of a radiotelegram ($P_A$) to the anticipated reception of the next radiotelegram ($P_A$) from the transmitter (V1-V4) concerned.

11. Radio transmission system according to any one of the preceding Claims, **characterised in that** the radio transmitter is an element of a measuring device (V1-V4), wherein it is adapted to send measurement data of the measuring device in radiotelegrams ($P_A$) to the radio receiver (E).

12. Radio system according to Claim 11, **characterised in that** the measuring device is a consumption meter.

13. Radio system according to Claim 12, **characterised in that** the consumption meter is an electronic heating cost distributor, water meter, gas meter, calorimetric meter or electricity meter.

**Revendications**

1. Système de radiotransmission comprenant au moins un émetteur radio (V), lequel présente un circuit de commande d'émission et est installé, de sorte que des radiotélégrammes sont émis selon un schéma d'intervalles d'émission donné dans des intervalles de temps entre lesquels des pauses ont lieu, et comprenant au moins un récepteur radio (E), lequel comporte un circuit de commande de réception, lequel est installé de sorte que le récepteur radio (E) est commuté pour réception conformément au schéma d'intervalles d'émission pour la durée des intervalles de temps de préparation de réception (TA), pour recevoir des radiotélégrammes de l'émetteur radio (V), l'émetteur radio (V) comportant un registre d'horloge avec des moyens de mesure du temps permettant de déterminer les moments d'émission et un indicateur de fréquence porteuse permettant de mettre à disposition la fréquence d'émission radio, **caractérisé en ce que** le temps indiqué par le registre d'horloge de l'émetteur radio (V) dépend de la fréquence de l'indicateur de fréquence porteuse en tant que mesure de cycle de référence, et **en ce que** le récepteur radio (E) est installé, dans un mode de fonctionnement de recherche, afin de réaliser une recherche automatique de fréquence de réception radio avec une fréquence de recherche de réception radio décroissante dans les intervalles de temps de mise à disposition de la réception (TA), afin de synchroniser la fréquence de réception radio du récepteur radio (E) sur la fréquence d'émission radio de l'émetteur radio (V).

2. Système de radiotransmission selon la revendication 1, **caractérisé en ce que** le registre d'horloge de l'émetteur radio (V) reçoit son impulsion d'horloge par l'indicateur de fréquence porteuse.

3. Système de radiotransmission selon la revendication 1, **caractérisé en ce que** le registre d'horloge de l'émetteur radio (V) comprend un générateur de cycle et est installé, de sorte que les temps déterminés à l'aide du moyen de mesure de temps par l'accumulation des cycles du générateur de cycle sont corrigés en fonction de la mesure d'une mesure de temps de référence ou d'une mesure de cycle de référence, laquelle est dérivée de la fréquence de l'indicateur de fréquence porteuse.

4. Système de radiotransmission selon la revendication 3, **caractérisé en ce que** l'émetteur radio (V) est installé, de sorte que

   a) l'indicateur de fréquence porteuse est actionné dans des intervalles de temps pour des phases d'activation courtes,
   b) pendant les phases d'activation courtes, la fréquence, la durée des périodes ou une mesure pouvant être dérivée de celle-ci du générateur de cycles de l'émetteur radio peuvent être déterminées comme mesure de cycle du registre d'horloge sur la base d'une mesure de temps de comparaison dérivée de l'indicateur de fréquence porteuse et
   c) lorsque la mesure du cycle déterminée s'éloigne de la valeur théorique, le temps accumulé à l'aide du moyen de mesure de temps est corrigé en fonction de la mesure de l'écart.

5. Système de radiotransmission selon la revendication 4, **caractérisé en ce que** l'émetteur radio (V) est installé, de sorte que

   - le nombre de cycles (T2) de l'indicateur de fréquence porteuse est compté grâce à la durée d'un nombre prédéterminé de cycles (T1) du générateur de cycles de l'émetteur radio,
   - l'écart du nombre de cycles est déterminé entre le résultat du compteur et une valeur théorique et
   - le temps accumulé à l'aide du moyen de mesure de temps est corrigé en fonction de la différence du nombre de cycles.

6. Système de radiotransmission selon la revendication 4, **caractérisé en ce que** l'émetteur radio (V) est installé, de sorte que

   - pendant les phases d'activation courtes de l'indicateur de fréquence porteuse, la fréquence du registre d'horloge est mesurée dans un intervalle de temps correspondant à un nombre déterminé de cycles de l'indicateur de fréquence porteuse,
   - l'écart de la valeur de mesure de fréquence est déterminé par une valeur théorique et
   - le temps accumulé à l'aide du moyen de mesure de temps est corrigé en fonction de l'écart.

**7.** Système de radiotransmission selon l'une quelconque des revendications précédentes, **caractérisé en ce que** le circuit de commande de réception est installé, de sorte que, sur la base des valeurs théoriques relatives aux écarts de temps, des radiotélégrammes consécutifs (PA) de l'émetteur radio (V1-V4) correspondant évaluent le moment respectif de l'envoi du radiotélégramme suivant attendu de l'émetteur radio (V) et commutent temporairement pour réception le récepteur radio (E) dans l'intervalle de temps de préparation de la réception (A), qui contient le moment estimé, afm de recevoir le radiotélégramme (TA).

**8.** Système de radiotransmission selon l'une quelconque des revendications précédentes, **caractérisé en ce que** le circuit de commande de réception est installé, de sorte que la durée maximale de l'intervalle de temps correspondant de mise à disposition de la réception (TA) est défini pour la réception d'un radiotélégramme (PA) suivant attendu par l'émetteur radio (V1-V4) correspondant en fonction de l'écart de temps entre la dernière réception réussie d'un radiotélégramme (TA) par l'émetteur (V) et la réception attendue du radiotélégramme suivant, et dans le sens d'une prolongation de la durée maximale de l'intervalle de temps de mise à disposition de la réception (TA) en cas d'allongement de l'écart de temps.

**9.** Système de radiotransmission selon l'une quelconque des revendications précédentes, **caractérisé en ce que** le circuit de commande est installé, de sorte que la recherche automatique de fréquence de réception radio est réalisée avec une diminution continue de la fréquence de recherche de réception radio.

**10.** Système de radiotransmission selon l'une quelconque des revendications précédentes, **caractérisé en ce que** le circuit de commande de réception est installé, de sorte que la fréquence de lancement de recherche et la plage maximale de fréquence de recherche pour la recherche suivante de réception radio est déterminée en fonction de l'écart de temps entre la dernière réception réussie d'un radiotélégramme (PA) et la réception attendue du radiotélégramme (PA) suivant de l'émetteur (V1-V4) concerné.

**11.** Système de radiotransmission selon l'une quelconque des revendications précédentes, **caractérisé en ce que** l'émetteur est un élément d'un appareil de mesure (V1-V4), celui-ci étant installé, de sorte que des données de mesure de l'appareil de mesure sont envoyées dans les radiotélégrammes (PA) vers le récepteur radio (E).

**12.** Système de radiotransmission selon la revendication 11, **caractérisé en ce que** l'appareil de mesure est un appareil de mesure de consommation.

**13.** Système de radiotransmission selon la revendication 12, **caractérisé en ce que** l'appareil de mesure de consommation est un répartiteur électronique de frais de chauffage, un compteur d'eau, un compteur de gaz, un calorimètre ou un compteur de courant.

# Fig. 1

V2

V1

E

V3

V4

# Fig. 2

V1

V2
V3
V4

E

T

P

P

P

T

T

$t \rightarrow$

# Fig. 3

$t_m$

$t_s$

$t_p$

$f_s$

N Takte

$f_p$

N Takte

$f_m$

N Takte

$f_s$

B

1

2

B

$T_A$

$T_A$

## Fig. 4

a)  $t_c$   $\vdash$X   $t_i$

b)  $T_1$   1. Taktgeber

c)  $T_2$   2. Taktgeber   $t_c$

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1028403 A2
- EP 1037185 A2
- EP 1392078 A2